# EUROPÄISCHE PATENTANMELDUNG

(11) **EP 1 699 142 A1**
(43) Veröffentlichungstag der Anmeldung: **06.09.2006**
(21) Anmeldenummer: 06002654.9
(22) Anmeldetag: 09.02.2006
(51) Int. Cl.: H04B 1/713

(54) **Verfahren zur Analyse von Funksignalen**

(30) Priorität: 03.03.2005 DE 102005009800
(71) Anmelder: Rohde & Schwarz GmbH & Co. KG, 81671 München (DE)
(72) Erfinder: Kühne, Jens, 85614 Kirchseeon (DE); Weth, Stefan, 81735 München (DE)
(74) Vertreter: Körfer, Thomas

(57) **Zusammenfassung**

Die Erfindung betrifft ein Verfahren zur Analyse von aus einzelnen Funksignalabschnitten bestehenden Funksignalen. Es wird eine Signalgesamtheit (1) empfangen und ein Spektrogramm mit einer ersten Bandbreite ermittelt. Das Spektrogramm wird mit einer ersten Genauigkeit ausgewertet und es wird zumindest ein Signalabschnitt (13, 14) in dem Spektogramm ermitttelt. Für den zumindest einen Signalabschnitt (14) wird ein entsprechender Spektogrammausschnitt (15) mit einer zweiten Bandbreite festgelegt. Der Spektogrammausschnitts (15) wird mit einer gegenüber der ersten Genauigkeit erhöhten zweiten Genauigkeit ausgewertet.

## Beschreibung

Die Erfindung betrifft ein Verfahren zur Analyse von aus einzelnen Funksignalabschnitten bestehenden Funksignalen.

Bei einer Funkaufklärung stellt sich häufig das Problem, aus einer Funksignalgesamtheit diejenigen Signalabschnitte zu analysieren, die zu einem bestimmten Emitter gehören. Da für Funksignale häufig Frequenzhopping-Verfahren verwendet werden, gehören zu einem Funksignal mehrere Signalabschnitte. Zunächst wird breitbandig eine aus mehreren, auch zu unterschiedlichen Emittern gehörenden Signalabschnitten bestehende Funksignalgesamtheit erfaßt. Auf der Basis eines daraus berechneten Breitbandspektrums werden die Signalabschnitte für die Funksignale und für die Signalabschnitte bestimmte Parameter ermittelt, um somit eine Zuordnung der Funksignalabschnitte zu einem bestimmten Funksignal bzw. Emitter vornehmen zu können. Dabei verhindert die Unschärferelation die Zeit und die Frequenz gleichzeitig exakt zu bestimmen. Die aus dem berechneten Breitbandspektrum gewonnenen Analyseergebnisse eignen sich daher nur begrenzt zum Bestimmen der verwendeten Übertragungsverfahren oder Modulationsart.

Da die Zeitinformation einer großen Ungenauigkeit unterworfen ist, ist es insbesondere nicht möglich, die einzelnen Signalabschnitte, die von einem Emitter stammen, wieder zu einem vollständigen Funksignal zusammenzusetzen. Bei einem sogenannten Hopping-Verfahren werden einzelne Signalabschnitte auf unterschiedlichen Frequenzen gesendet. Wegen der bereits genannten Unschärferelation lassen sich jedoch die einzelnen Signalabschnitte nicht so exakt analysieren, daß sie im Anschluß daran zeitrichtig wieder zusammengesetzt werden können. Ein Erfassen eines vollständigen, zusammenhängenden Funksignals, wie es vor der Anwendung des Frequenzsprungverfahrens seitens des Emitters vorlag, ist nicht möglich.

Es ist daher die Aufgabe der Erfindung, ein Verfahren zu schaffen, welches die einzelnen Signalabschnitte mit einer höheren Genauigkeit analysieren kann, sowie ein entsprechendes Computerprogramm und Computerprogramm-Produkt anzugeben.

Die Aufgabe wird durch das erfindungsgemäße Verfahren gemäß Anspruch 1 gelöst. Die Ansprüche 8 und 9 betreffen ein entsprechendes Computerprogramm, während Anspruch 10 ein entsprechendes Computerprogramm-Produkt betrifft.

Bei dem erfindungsgemäßen Verfahren werden zunächst breitbandig eine Vielzahl von Signalabschnitten erfaßt, indem eine Signalgesamtheit in einem bestimmten Frequenzbereich durch einen Empfänger empfangen wird. Aus dieser Signalgesamtheit wird nun ein Spektrogramm mit einer ersten Bandbreite ermittelt. Innerhalb des Spektrogramms, welches als Information die Sendeleistung in Abhängigkeit von der Frequenz sowie der Zeit enthält, werden dort erkennbare Signalabschnitte ermittelt.

Die so in dem Spektrogramm einer ersten Bandbreite ermittelten Signalabschnitte werden anschließend schmalbandig, also mit einer schmalen zweiten Bandbreite, analysiert. Hierzu wird ein dem gewählten Signalabschnitt entsprechender Spektrogrammausschnitt gewählt, für den dann mit einer der Bandbreite des gewählten Spektrogrammausschnitts entsprechenden zweiten Bandbreite eine Analyse durchgeführt wird. Durch die Anlayse dieses schmalbandigen Signals ist es möglich, sowohl die Frequenz als auch die Zeit des Signals, z.B. die Startzeit, mit einer größeren Exaktheit zu bestimmen, so daß anschließend die einzelnen Signalabschnitte, die als zu einem bestimmten Funksignal gehörig erkannt werden, auch wieder zu dem ursprünglichen Signal zusammengesetzt werden können.

In den Unteransprüchen sind vorteilhafte Weiterbildungen des erfindungsgemäßen Verfahrens dargestellt.

Besonders vorteilhaft ist es, daß vor der Analyse des Spektrogrammausschnitts zunächst die Mittenfrequenz des Signalabschnitts ermittelt wird und anschließend der entsprechende Spektrogrammausschnitt schmalbandig auf Null gemischt wird. Nachdem der interessierende Spektrogrammausschnitt auf Null gemischt ist, kann nun eine Analyse des schmalbandig vorliegenden Signalabschnitts durchgeführt werden, wobei nur noch niedrigere Frequenzen zu berücksichtigen sind.

Weiterhin ist es vorteilhaft, vor der Analyse des relevanten Spektrogrammausschnitts eine Reduktion der Daten durchzuführen. Durch eine Reduktion der Daten reduziert sich der erforderliche Rechenaufwand zur Analyse, zu der bevorzugt eine FFT (Fast-FourierTransformation) verwendet wird, so daß ein Einsatz in einem Echtzeit-Analysesystem möglich wird.

Weiterhin ist es vorteilhaft, für einen bestimmten Frequenzbereich der ersten Bandbreite eine automatische Analyse durchzuführen. Dies hat insbesondere den Vorteil, daß die bestimmten Spektrogrammausschnitte, für die eine schmalbandige Analyse erfolgen soll, nicht mehr einzeln untersucht werden müssen, sondern zu einem bestimmten Signal zugehörige Signalabschnitte automatisch analysiert werden.

Das erfindungsgemäße Verfahren ist in der Zeichnung dargestellt und wird anhand der nachfolgenden Beschreibung näher erläutert. Es zeigen:
- Fig. 1: ein Blockschaltbild zur Durchführung des Verfahrens;
- Fig. 2: eine erste Darstellung eines Spektrogramms erster Bandbreite;
- Fig. 3: ein Analyseergebnis eines in Fig. 1 markierten schmalbandigen Bereichs;
- Fig. 4: ein weiteres Ergebnis einer schmalbandigen Analyse des in Fig. 2 markierten Bereichs des Spektrogramms;
- Fig. 5: eine weitere Darstellung eines Spektrogramms.

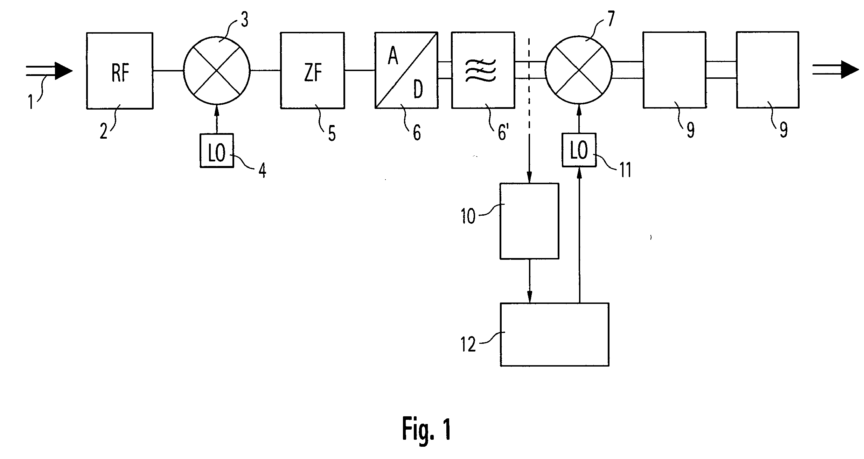

Anhand des Blockschaltbilds in Fig. 1 soll das erfindungsgemäße Verfahren erläutert werden. Das erfindungsgemäße Verfahren dient der Funkaufklärung, bei dem in einer Signalgesamtheit einzelne Funksignale enthalten sind, die wiederum jeweils aus Signalabschnitten zusammengesetzt sind. Die einzelnen Signalabschnitte eines Funksignals werden auf unterschiedlichen Trägerfrequenzen durch einen Emitter gesendet. In der Signalgesamtheit können mehrere Funksignale verschiedener Emitter gleichzeitig vorhanden sein. Die dann auf einer Vielzahl von einzelnen Trägerfrequenzen gesendeten Signalabschnitte eines bestimmten Funksignals können nicht ohne weiteres einem einzelnen Emitter zugeordnet werden.

Die Signalgesamtheit 1 wird erfindungsgemäß zunächst durch einen Empfänger 2 empfangen. Das Hochfrequenzsignal wird einem Mischer 3 zugeführt, der unter Berücksichtigung einer Frequenz eines ersten lokalen Oszillators 4 die empfangene Signalgesamtheit auf eine Zwischenfrequenz ZF mischt. Das Zwischenfrequenzsignal 5 wird einem Analog/Digital-Wandler 6 zugeführt. Die Abtastrate muss entsprechend dem Nyquist-Theorem mindestens dem Zweifachen der höchsten zu analysierenden Bandbreite entsprechen. Das unterabgetastete Signal wird einem Tiefpassfilter 6' zugeführt.

Zur Analyse wird nun ein bestimmter Zeitabschnitt des so vorliegenden Signals gespeichert. Aus diesen gespeicherten Daten wird mittels diskreter Fouriertransformation (FFT) ein Spektrogramm berechnet. Das berechnete Spektrogramm 10 wird, wie es nachfolgend noch beschrieben wird, dargestellt. Das Spektrogramm trägt die Pegelinformation über die Zeit und die Frequenz auf. Da zwischen der Zeit-und Frequenzgenauigkeit eine Unschärferelation besteht, lassen sich beide Informationen nicht mit beliebiger Genauigkeit ermitteln. Das Spektrogramm 10 dient daher lediglich einer Grobvermessung der darin enthaltenen Signalabschnitte. Um nun eine exaktere Information über das Signal zu erhalten, werden aus dem Spektrogramm 10 diejenigen Anteile ermittelt, in denen erkennbar ein Signal vorhanden ist. Bei einer Grobvermessung lassen sich ungefähre Werte z.B. für die Startzeit, Stopzeit, Mittenfrequenz usw. bestimmen.

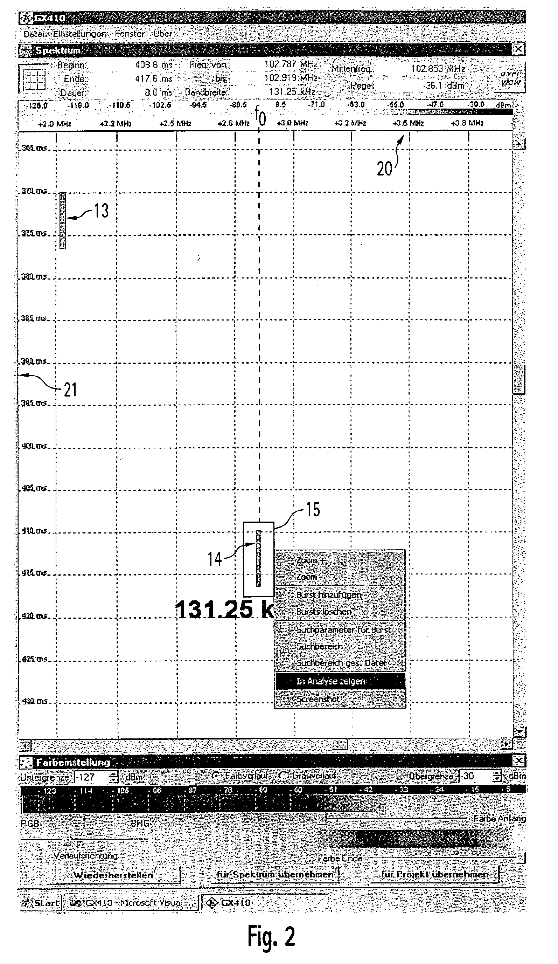

Das Spektrogramm deckt eine Bandbreite B ab und betrachtet einen Zeitraum T. Ein Signalabschnitt eines Emitters ist in dem Spektrogramm nun erkennbar, da in dem Spektrogramm zu einem bestimmten Zeitpunkt t₀ mit einer bestimmten Mittenfrequenz f₀ ein Signal erkennbar ist, wie es beispielhaft in der Fig. 2 dargestellt ist. Dieses Signal ist jedoch in dem Spektrogramm nur mit einer erheblichen Unschärfe analysierbar, wie es bereits erläutert wurde.

In der Zeit-/Frequenzebene des Spektrogramms wird nun um die Mittenfrequenz f₀ und den Zeitpunkt t₀ ein Bereich als relevanter Spektrogrammausschnitt festgelegt. Um nun für diesen relevanten Spektrogrammausschnitt, der einem bestimmten Signalabschnitt entspricht, eine exaktere Analyse durchführen zu können, wird für die weitere Analyse lediglich der relevante Spektrogrammausschnitt berücksichtigt.

Für den relevanten Spektrogrammausschnitt wird zunächst dessen Mittenfrequenz f₀ in Schritt 12 grob bestimmt. Mit Hilfe dieser Mittenfrequenz f₀ wird ein zweiter lokaler Oszillator 11 so angesteuert, daß das Signal mittels eines weiteren Mischers 7 auf Null ins Basisband gemischt werden kann. Nach Filterung mit einem Tiefpass 8 liegt nun zur weiteren Analyse ein Signal mit einer geringeren Bandbreite vor, wobei die Bandbreite dem Frequenzbereich des relevanten Spektrogrammausschnitts entspricht.

In einem nächsten Schritt 9 findet eine Reduktion der zur Analyse herangezogenen Daten statt. Die Reduktion der Daten ist dabei in ihrem Umfang geringer als die Reduzierung der Bandbreite dies maximal zulassen würde. Dieses überabgetastete Signal kann in weiteren Analyseschritte der Ermittlung von präzisen Zeitparametern dienen.

Das Basisbandsignal, das dem schmalbandigen Signalabschnitt entspricht, wird nun im Zeitbereich und/oder im Frequenzbereich fein vermessen. Dabei werden charakteristische Parameter für den jeweiligen Signalabschnitt präzise ermittelt und z.B. in einer Datenbank abgelegt. Solche charakteristischen Parameter können Startzeit, Stopzeit, Mittenfrequenz, Bandbreite usw. sein.

Das Ermitteln der charakteristischen Parameter muß nicht automatisch für sämtliche in dem Spektrogramm erkannten Signalabschnitte durchgeführt werden. Stammen beispielsweise mehrere Signalabschnitte von demselben Ermitter, und haben diese von einem Ermitter stammenden Signalabschnitte dieselbe Länge sowie ein identisches Zeit-/Frequenzraster, so ist es ausreichend, die charakteristischen Parameter für lediglich einen Teil der erkannten Signalabschnitte zu ermitteln. Mit Hilfe des bekannten Zeitrasters wird so beispielsweise von bislang nur unscharf bestimmten Signalabschnitten die jeweilige Start- bzw. Stopzeit exakt berechnet. Hierzu wird auf die Zeitinformation aus den bereits fein vermessenen Signalabschnitten zurückgegriffen, die einen Rückschluß auf sämtliche Start-/Stopzeiten der übrigen Signalabschnitte desselben Funksignals ermöglichen.

Aus den Zeitinformationen lässt sich ein Zeitraster ermitteln. Zusammen mit den bereits ermittelten Startzeiten kann mit dem Zeitraster auch für die übrigen Signalabschnitte deren Startzeit rechnerisch ermittelt werden. Da einzelne Signalabschnitte eines Funksignals - ein festes Zeitraster vorausgesetzt - immer nur zu bestimmten Startzeiten beginnen können, lassen sich damit die Signalabschnitte bestimmen, die zusammen ein Funksignal bilden und folglich zu einem Emitter gehören. Liegen damit die einzelnen Signalabschnitte, die zu einem Funksignal eines Emitters gehören, inklusive ihrer charakteristischen Parameter vor, so können die einzelnen Signalabschnitte zu einem gesamten Funksignal zusammengesetzt werden.

Um eine Echtzeit-Analyse einer Signalgesamtheit 1 zu ermöglichen, wird kontinuierlich aus den empfangenen Hochfrequenzsignalen ein Spektrogramm ermittelt und für die darin enthaltenen Signalabschnitte bzw. deren jeweils relevante Spektrogrammausschnitte das Zwischenfrequenzsignal schmalbandig ins Basisband gemischt. Für die einzelnen relevanten Spektrogrammausschnitte können dabei mehrere (1 bis N) parallel arbeitende Analyseketten eingesetzt werden. Es erfolgt dann zentral lediglich die Ermittlung des Spektrogramms aus den empfangenen Hochfrequenzsignalen. Das Erkennen einzelner Signalabschnitte sowie das Ermitteln der entsprechenden relevanten Spektrogrammausschnitte erfolgt dagegen in mehreren parallelen Ketten, so daß sämtliche Signalabschnitte in Echtzeit ermittelt werden können und so ebenfalls in Echtzeit ein zusammengesetztes Funksignal für den jeweiligen Emitter ausgegeben werden kann.

Um in dem berechneten Spektrogramm die relevanten Spektrogrammausschnitte zu ermitteln, die zu jeweils einem Signalabschnitt gehören, können verschiedene Parameter herangezogen werden. Solche Kriterien für das Ermitteln der relevanten Spektrogrammausschnitte können z.B. die Länge der einzelnen Signalabschnitte, ihre Bandbreite, das Signal-/Rauschverhältnis oder auch ein bestimmtes Zeit-/Frequenzraster sein. Zusätzlich kann auch noch ein vorhandener Peilwert als Kriterium verwendet werden.

Die Analyse des schmalbandigen Basisbandsignals kann entweder manuell durchgeführt werden oder aber automatisiert. Bei einer manuellen Analyse wird zunächst das schmalbandige Basisbandsignal graphisch dargestellt. Charakteristische Punkte des Signals werden nun mit Hilfe eines Cursors erfaßt, wobei in Abhängigkeit von der gewählten Darstellung des schmalbandigen Basisbandsignals jeder Cursorposition ein bestimmter Wert zugeordnet ist.

In Fig. 2 ist ein Spektrogramm für eine Beispielmessung gezeigt. Die berechneten Signalpegel werden als Funktion der Zeit und der Frequenz aufgetragen. Es ergibt sich ein Rechteck mit einer relativen Frequenzachse 20 und Zeitachse 21. In dem berechneten Spektrogramm ist ein Ausschnitt dargestellt, innerhalb dessen zwei Zeit-Frequenzbereiche 13, 14 mit signifikant erhöhter Leistung erkennbar sind. Es ist daher anzunehmen, daß die beiden Bereiche 13, 14 jeweils einem Signalabschnitt entsprechen.

Für den zweiten Signalabschnitt 14 ist ein relevanter Spektrogrammausschnitt 15 dargestellt. Der dargestellte relevante Spektrogrammausschnitt 15 hat eine Bandbreite von beispielsweise 131,25 kHz. Weiter wird aus dem Spektrogramm die Mittenfrequenz f₀ des relevanten Spektrogrammausschnitts 15 ermittelt. Die Kenntnis der Mittenfrequenz f₀ des relevanten Spketrogrammausschnitts wird dazu verwendet, den weiteren lokalen Oszillator 11 abzustimmen, um so mit Hilfe des weiteren Mischers 7 den relevanten Spektrogrammausschnitt 15 auf Null zu mischen.

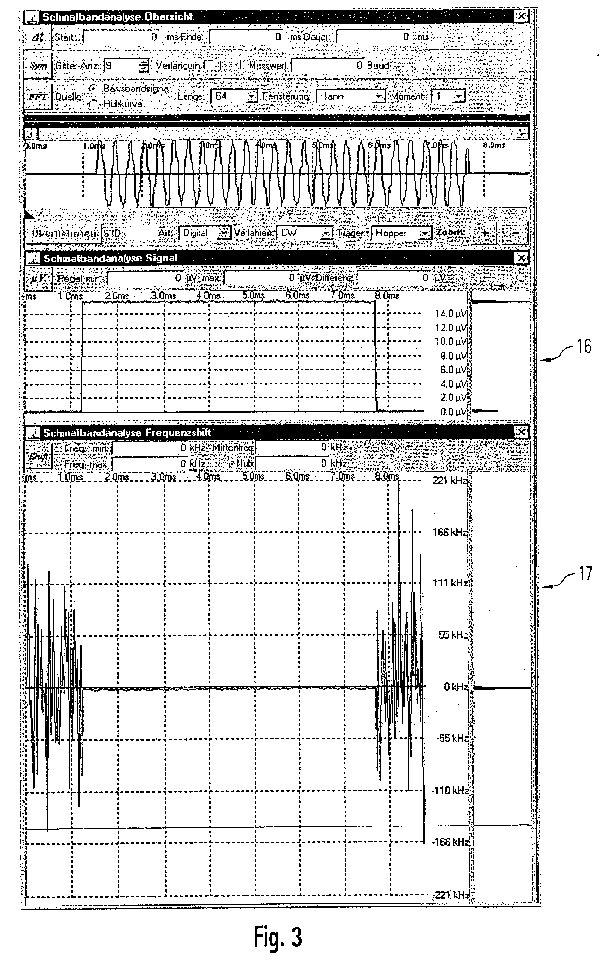

Aus dem nun vorliegenden schmalbandigen Basisbandsignal werden verschiedene charakteristische Parameter ermittelt, wie es in Fig. 3 beispielhaft dargestellt ist. Zur Ermittlung der charakteristischen Parameter wird der Signalabschnitt zeitabhängig dargestellt. In Fig. 3 sind beispielhaft der Pegelverlauf 16 sowie ein Frequenz-Shift 17 des schmalbandigen Basisbandsignals dargestellt.

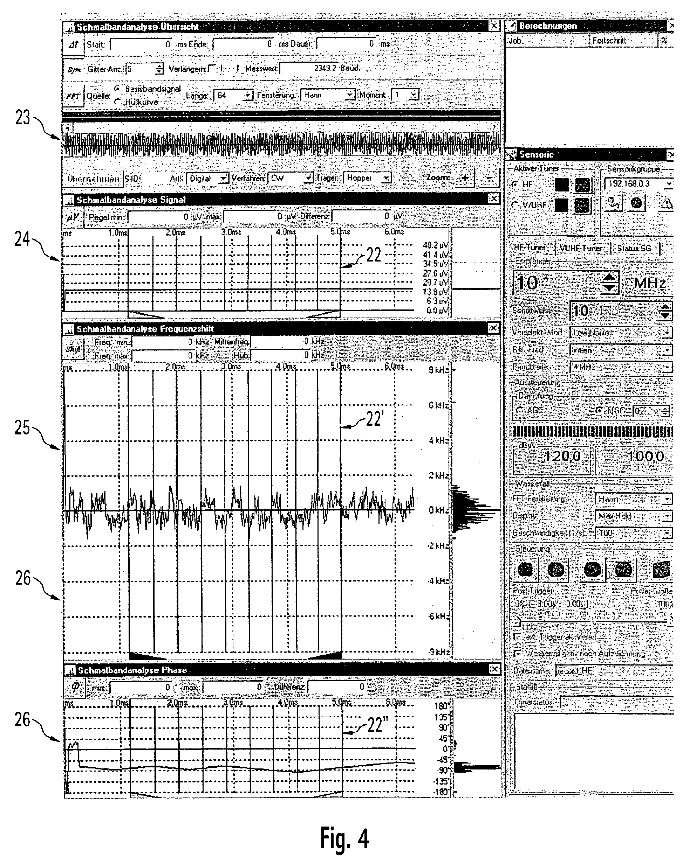

Nachdem die Mittenfrequenz f₀ des relevanten Spektrogrammausschnitts 15 ermittelt wurde und das Signal in dem Bereich des relevanten Spektrogrammausschnitts 15 neuerlich auf Null gemischt wurde, wird die Schmalbandanalyse durchgeführt. Die Fig. 4 zeigt weitere mögliche zu analysierende Parameter. Zunächst wird der zeitliche Verlauf des schmalbandigen Signals in einem ersten Fenster 23 angezeigt. Mit Hilfe eines in dem ersten Fenster 23 nicht dargestellten Cursers kann ein bestimmter, interessierender Abschnitt markiert werden, für den der zeitliche Verlauf charakteristischer Werte, wie beispielsweise Pegel, Frequenzshift oder Phase, in einem zweiten Fenster 24, einem dritten Fenster 25 oder einem vierten Fenster 26 dargestellt werden. In dem zweiten bis vierten Fenster 24 bis 26 können wiederum für einen bestimmten Signalabschnitt, z. B. durch Verwendung eines Cursers 22 Werte zu bestimmten Zeiten ermittelt werden. In dem dargestellten Ausführungsbeispiel wirkt sich der in dem zweiten Fenster 24 gesetzte Curser 22 entsprechend auf den in dem dritten Fenster 25 bzw. vierten Fenster 26 dargestellten Teil des Signalabschnitts aus.

Damit kann durch Markierung einer prägnanten Stelle in einem der drei Fenster 24 bis 26 der jeweils zugehörige Wert sowohl für den Pegel als auch für die Frequenzshift als auch für die Phase gleichzeitig ermittelt werden. Die jeweils zu ermittelnden charakteristischen Parameter können durch einen Nutzer eingestellt werden.

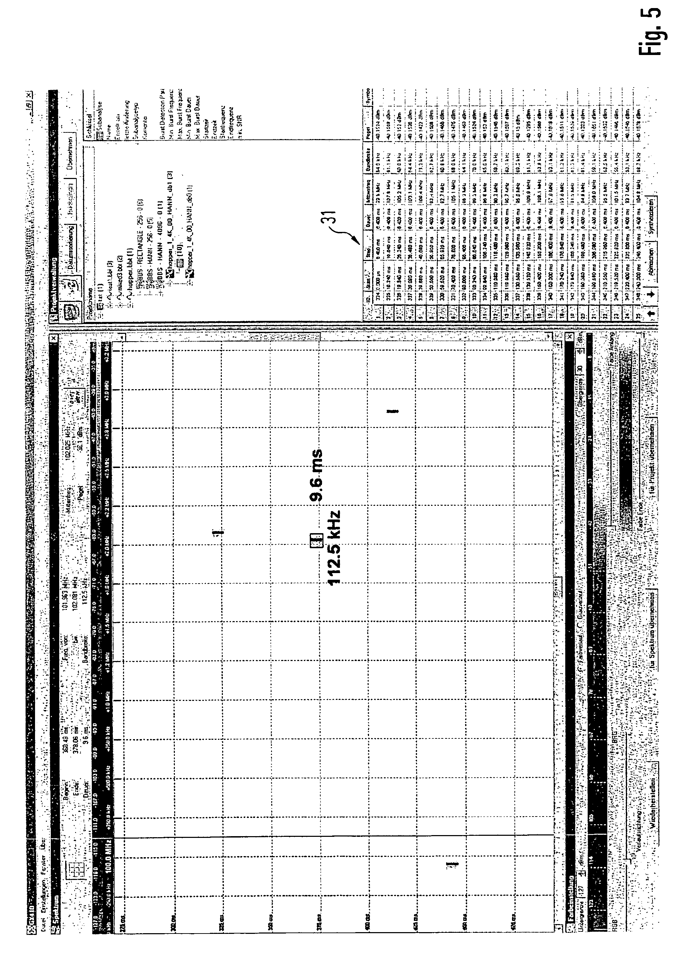

Wie es bereits erläutert wurde, werden die in dem Spektrogramm ermittelten Signalabschnitte zunächst grob vermessen und anschließend nach einer neuerlichen Mischung des Basisbandsignals auf Null fein vermessen. Sowohl die grob vermessenen Werte als auch die anschließend in der Schmalband-Analyse fein vermessenen Werte werden in einer Datenbank abgelegt. In der Fig. 5 ist es dargestellt, wie zu einer Reihe von bereits schmalbandig analysierten Signalabschnitten die Einträge in einer Datenbank als Liste 31 dargestellt aussehen können. Die Einträge werden zunächst mit einer ID versehen, die jeden Eintrag eindeutig bezeichnet. Neben dieser ID ist die Startzeit sowie die Stopzeit angegeben. Aus der Start- und der Stopzeit lässt sich die Dauer eines einzelnen Signalabschnitts ermitteln. Mit Hilfe dieser Zeitinformationen kann dann das Zeitraster des Funksignals und damit eines bestimmten Emitters festgelegt werden. Weiterhin wird eine ermittelte Mittenfrequenz, die Bandbreite des Signalabschnitts sowie sein Pegel in der Datenbank abgespeichert. Neben den hier dargestellten charakteristischen Parametern sind auch weitere Informationen vorstellbar.

So ist es z. B. möglich, eine bestimmte Modulationsart dem entsprechenden Signalabschnitt zuzuordnen. Die Kenntnis dieser charakteristischen Parameter, insbesondere der Mittenfrequenz, erlaubt es dann, das Frequenzsprungverfahren rückgängig zu machen und so das ursprüngliche Quellsignal zurück zu erlangen.

Die Erfindung ist nicht auf das dargestellte Ausführungsbeispiel beschränkt. Sämtliche beschriebenen oder gezeichneten Elemente sind im Rahmen der Erfindung beliebig miteinander kombinierbar.

## Patentansprüche

1. Verfahren zur Analyse von aus einzelnen Funksignalabschnitten bestehenden Funksignalen, mit folgenden Verfahrensschritten:
- Empfangen einer Signalgesamtheit (1)
- Erstellen eines Spektrogramms mit einer ersten Bandbreite
- Auswerten des Spektrogramms mit einer ersten Genauigkeit und Ermitteln zumindest eines Signalabschnitts (13, 14) in dem Spektrogramm
- Festlegen eines dem zumindest einen Signalabschnitt (14) entsprechenden Spektogrammausschnitts (15) mit einer zweiten Bandbreite
- Auswerten des Spektogrammausschnitts (15) mit einer gegenüber der ersten Genauigkeit erhöhten zweiten Genauigkeit.

2. Verfahren nach Anspruch 1,
**dadurch gekennzeichnet,**
**dass** vor der Analyse des Spektogrammausschnitts (15) jeweils eine Mittenfrequenz (f₀) des Spektogrammausschnitts (15) ermittelt wird und anschließend der Spektogrammausschnitt (15) auf Null gemischt wird.

3. Verfahren nach Anspruch 1 oder 2,
**dadurch gekennzeichnet,**
**dass** vor der Analyse eines Spektrogrammausschnitts (15) eine Datenreduktion (9) durchgeführt wird.

4. Verfahren nach einem der Ansprüche 1 bis 3,
**dadurch gekennzeichnet,**
**dass** für einen bestimmten Frequenzbereich der ersten Bandbreite eine automatische Analyse der darin ermittelten Signalabschnitte (13, 14) durchgeführt wird.

5. Verfahren nach einem der Ansprüche 1 bis 4,
**dadurch gekennzeichnet,**
**dass** für den dem Spektogrammausschnitt (15) entsprechenden Signalabschnitt (14) charakteristische Parameter bestimmt werden.

6. Verfahren nach einem der Ansprüche 1 bis 5,
**dadurch gekennzeichnet,**
**dass** der Signalabschnitt (14) unter Angabe der charakteristischen Parameter in einem Speichermedium gespeichert wird.

7. Verfahren nach Anspruch 6,
**dadurch gekennzeichnet,**
**dass** aus mehreren in dem Speichermedium gespeicherten Signalabschnitten (13, 14) anhand ihrer charakteristischen Parameter zusammengehörende Signalabschnitte ermittelt werden und zu einem Funksignal zusammengesetzt werden.

8. Computerprogramm mit Programmcode-Mitteln, um alle Schritte gemäß einem der Ansprüche 1 bis 7 durchführen zu können, wenn das Programm auf einem Computer oder einem digitalen Signalprozessor ausgeführt wird.

9. Computerprogramm mit Programmcode-Mitteln, um alle Schritte gemäß einem der Ansprüche 1 bis 7 durchführen zu können, wenn das Programm auf einem maschinenlesbaren Datenträger gespeichert ist.

10. Computerprogramm-Produkt mit auf einem maschinenlesbaren Datenträger gespeicherten Programmcode-Mitteln, um alle Schritte gemäß einem der Ansprüche 1 bis 7 durchführen zu können, wenn das Programm auf einem Computer oder einem digitalen Signalprozessor ausgeführt wird.
